# EUROPÄISCHE PATENTSCHRIFT

(11) **EP 1 042 817 B1**
(45) Veröffentlichungstag und Bekanntmachung des Hinweises auf die Patenterteilung: **14.05.2008**
(21) Anmeldenummer: 99962032.1
(22) Anmeldetag: 25.10.1999
(51) Int. Cl.: H01L 29/739

(54) **BIPOLARES HOCHVOLT-LEISTUNGSBAUELEMENT**
BIPOLAR HIGH-VOLT POWER COMPONENT
COMPOSANT DE PUISSANCE BIPOLAIRE HAUTE TENSION

(30) Priorität: 26.10.1998 DE 19849332
(43) Veröffentlichungstag der Anmeldung: 11.10.2000
(73) Patentinhaber: Infineon Technologies AG, 81669 München (DE)
(72) Erfinder: WERNER, Wolfgang, D-81545 München (DE); PFIRSCH, Frank, D-81545 München (DE)
(74) Vertreter: Müller - Hoffmann & Partner
(86) Internationale Anmeldenummer: PCT/DE1999/003404
(87) Internationale Veröffentlichungsnummer: WO 2000/025364

(56) Entgegenhaltungen:
- WO-A-98/38681
- DE-A- 19 604 043

## Beschreibung

Die vorliegende Erfindung betrifft ein bipolares Hochvolt-Leistungsbauelement mit einem Halbleiterkörper, auf dem wenigstens zwei voneinander beabstandete Elektroden vorgesehen sind, zwischen denen eine Driftstrecke in einem Halbleitergebiet eines ersten Leitungstyps ausgebildet ist, in dem floatende Zonen des zweiten, zum ersten Leitungstyp entgegengesetzten Leitungstyps vorgesehen sind, die sich zwischen der einen Elektrode und der anderen Elektrode erstrecken.

Bei bipolaren Halbleiterbauelementen, wie beispielsweise Dioden, Bipolartransistoren oder IGBT's (Bipolartransistor mit isoliertem Gate), wird deren dynamisches Verhalten sehr stark durch die in der Driftstrecke, also bei einem Bipolartransistor in der Basis, vorhandenen Minoritätsladungsträger bestimmt. Je kleiner nämlich die Basisweite ist, eine um so höhere Grenzfrequenz kann schließlich erreicht werden.

Es ist nun in letzter Zeit gelungen, bei Bipolartransistoren die Basisweite bis auf ca. 30 nm zu vermindern, was zu der bereits erwähnten Reduktion an gespeicherten Minoritätsladungsträgern in der Basis führt, so dass eine Erhöhung der Grenzfrequenz möglich wäre. So hat sich gezeigt, dass bei einer Verringerung der Basisweite von Bipolartransistoren bis herunter auf etwa 30 nm die Menge der gespeicherten Minoritätsladungsträger in der Basis bzw. die Diffusionskapaziät zu verringern sind, was schließlich zu einer entsprechenden Erhöhung der Grenzfrequenz bis ca. 50 GHz führt, wobei aber gleichzeitig die Spannungsfestigkeit auf wenige Volt reduziert wird.

Bei Hochvolt-Leistungsbauelementen, wie beispielsweise IGBT's, an denen eine Spannung bis zu mehreren kV liegen kann, oder bei Dioden wird die Basisweite durch die geforderte Spannungsfestigkeit und den Aufbau des Hochvolt-Leistungsbauelementes an sich bestimmt. Jedoch begrenzen ganz generell die in der Driftzone, also bei einem Bipolartransistor die in der Basiszone gespeicherten Minoritätsladungsträger die maximale Betriebsfrequenz oder lassen dynamische Verluste beim Ein- und Ausschalten des Bauelementes entstehen.

Zwar können dynamische Verluste in bipolaren Hochvolt-Leistungsbauelementen vermindert werden, indem beispielsweise bei einem IGBT durch Reduzierung des Emitterwirkungsgrades die Menge der gespeicherten Minoritätsladungsträger vermindert wird. Ein derartiges Vorgehen führt aber zwangsläufig zu einer Erhöhung der statischen Verluste. Auch ist es möglich, die Lebensdauer von Ladungsträgern durch Dotierung mit einem entsprechenden Lebensdauerkiller, also beispielsweise Gold oder Platin, oder durch Elektronen- oder Heliumbestrahlung zu reduzieren, wodurch dynamische Verluste vermindert werden können.

Ein derartiges Vorgehen führt aber auch zu einer gleichzeitigen Erhöhung der statischen Verluste.

Im Einzelnen ist aus WO 98/38681 A ein IGBT in Planartechnologie bekannt, bei dem durch Einführung einer Abschirmungszone, die um eine Basiszone angeordnet ist, die Minoritätsladungsträgerdichte an der Katodenseite des IGBT's angehoben wird, was zu einer Reduzierung der Durchlassspannung führt. Das aufgrund des Konzentrationsgefälles zwischen der Abschirmungszone und der Basiszone entstehende Driftfeld bewirkt, dass eine Innenzone nicht mehr als Senke für die Minoritätsladungsträger wirkt. Damit die Durchbruchspannung des IGBT's durch die Einführung der Abschirmungszone nicht reduziert wird, wird ein nicht angeschlossenes, floatendes Gebiet hoher Leitfähigkeit im Bereich der Innenzone angeordnet, dessen unterer Rand tiefer in der Innenzone liegt als der untere Rand der Abschirmungszone. Das nicht angeschlossene floatende Gebiet ist vom entgegengesetzten Leitungstyp wie die Abschirmungszone und die Innenzone.

Es ist Aufgabe der vorliegenden Erfindung, ein bipolares Hochvolt-Leistungsbauelement zu schaffen, bei dem trotz einer relativ großen Driftstrecke Schaltverluste erheblich vermindert und damit mögliche Betriebsfrequenzen beträchtlich gesteigert sind, ohne die Durchlasseigenschaften des bipolaren Hochvolt-Leistungsbauelement zu beeinträchtigen.

Diese Aufgabe wird bei einem bipolaren Hochvolt-Leistungsbauelement der eingangs genannten Art erfindungsgemäß dadurch gelöst, dass das Halbleitergebiet und die floatenden Zonen jeweils eine Dotierungskonzentration von etwa 5 x 10¹⁴ bis 5 x 10¹⁶ Ladungsträger cm⁻³ aufweisen.

Die in dem Halbleitergebiet vorgesehenen, floatenden Zonen des zweiten, zum ersten Leitungstyp entgegengesetzten Leitungstyps erstrecken sich von der Nähe der einen Elektrode bis zu der Nähe der anderen Elektrode und dienen dazu, beim Einschalten bzw. Ausschalten des Leistungsbauelements Ladungsträger des zweiten Leitungstyps in das Halbleitergebiet abzugeben bzw. von diesem aufzunehmen.

Die Dotierungen des Halbleitergebietes und der floatenden Zonen werden so eingestellt, dass das Halbleitergebiet und die Halbleiterzonen einander "kompensieren", um so hohe Sperrspannungen erreichen zu können. Hierzu werden Dotierungen zwischen 5 x 10¹⁴ und 5 x 10¹⁶ Ladungsträger cm⁻³ gewählt.

Es ist nicht wesentlich, dabei eine möglichst hohe n-Dotierung in beispielsweise einem n-leitenden Halbleitergebiet wie bei einem Unipolartransistor zu erreichen; vielmehr sollte der Widerstand der floatenden Halbleiterzonen, also im obigen Beispiel der p-leitenden Säulen so angepasst werden, dass ein ausreichend schnelles Abfließen der Löcher bei noch geringer Spannung erfolgt. Die für eine gute Leitfähigkeit im Durchlasszustand erforderliche Ladungsträgerüberschwemmung wird nämlich dann durch den p-leitenden Emitter zur Verfügung gestellt und durch die p-leitenden Säulen nicht negativ beeinflusst, da diese p-leitenden Säulen im Durchlassbetrieb nicht mit einem absaugenden p-leitenden Bereich verbunden sind, was erst beim Abschalten durch den p-MOS-Transistor geschieht.

Bei dem bipolaren Hochvolt-Leistungsbauelement wird ein "Kompromiss" zwischen dynamischen und statischen Verlusten (bei unveränderter Spannungsfestigkeit) umgangen. Hierzu werden in das Halbleitergebiet des ersten Leitungstyps, also beispielsweise in eine n-leitende Driftstrecke eines Bipolartransistors floatende Zonen des zweiten Leitungstyps, also p-leitende Zonen, durch Diffusion oder Implantation eingefügt. Diese floatenden Zonen, die bei einem n-leitenden Halbleitergebiet auch als "p-Säulen" bezeichnet werden können, haben die Aufgabe, die Minoritätsladungsträger, im vorliegenden Beispiel also Löcher, durch "ohmsche Leitung" in die zwischen den floatenden Zonen befindlichen Halbleitergebiet einzubringen bzw. aus diesen abzuleiten.

Es hat sich gezeigt, dass dieser Vorgang, nämlich das Einbringen von Minoritätsladungsträgern in die Halbleitergebiete aus den floatenden Zonen beim Einschalten und das Abführen der Minoritätsladungsträger aus den Halbleitergebieten in die floatenden Zonen beim Abschalten, sehr viel rascher als der Aufbau bzw. der Abbau der Minoritätsladungsträger durch Diffusion erfolgen kann.

Vorzugsweise sind die floatenden Zonen über jeweils einen MOS-Transistor mit einem Kanal des zweiten Leitungstyps bzw. einem Bipolartransistor mit einer Basis des ersten Leitungstyps an mit den beiden Elektroden verbundene aktive Bereiche des Leistungsbauelements angeschlossen. So sind beispielsweise bei einem IGBT mit einem n-leitenden Halbleitergebiet als Driftstrecke p-leitende Säulen durch einen pnp-Transistor an den Emitter bzw. die Anode des IGBT's und durch einen p-MOS-Transistor an das Kanal- bzw. Body-Gebiet des IGBT's angeschlossen. Beim Einschalten des IGBT's werden dann die Löcher über den pnp-Transistor und die p-leitenden Säulen in die Driftstrecke transportiert, während beim Abschalten der p-MOS-Transistor eingeschaltet wird, so dass die Minoritätsladungsträger, also die Löcher, aus dem n-leitenden Halbleitergebiet über die p-leitenden Säulen als Minoritätsladungsträger und den p-MOS-Transistor abfließen können.

In einer anderen Weiterbildung der Erfindung ist vorgesehen, dass der MOS-Transistor mit einem weiteren, den entsprechenden aktiven Bereich enthaltenden MOS-Transistor zusammengeschaltet ist. Dabei können insbesondere die Gates der beiden MOS-Transistoren miteinander verbunden sein.

Im obigen Beispiel ist somit das Gate des p-MOS-Transistors, über den die Minoritätsladungsträger aus der Driftstrecke abfließen, mit dem Gate eines n-MOS-Transistors verbunden. Abhängig von der Betriebsfrequenz kann es dann zweckmäßig sein, zur Reduzierung der Abschaltverluste zuerst den p-MOS-Transistor einzuschalten und sodann mit einer Verzögerung von beispielsweise 1 µs den n-MOS-Transistor auszuschalten. Diese Verzögerung kann durch eine getrennte Ansteuerung oder auch durch ein Verzögerungsglied, beispielsweise einen hochohmigen Widerstand zwischen den beiden Gates, erreicht werden. Das Verzögerungsglied kann dabei auch in dem Halbleiterchip des bipolaren Hochvolt-Leistungsbauelements integriert sein.

Die Erfindung ist besonders vorteilhaft bei einem IGBT anwendbar, da hier eine besonders hohe Überschwemmung mit Ladungsträgern auftritt, die dann sofort über die floatenden Zonen abgeführt werden können. Es hat sich gezeigt, dass ein nach der vorliegenden Erfindung aufgebauter IGBT gegenüber herkömmlichen IGBT's bei gleicher Durchlassspannung um bis zu 80 % niedrigere Ausschaltverluste aufweist. Selbst gegenüber einem sogenannten "Feldstopp-IGBT" können durch die Erfindung die Ausschaltverluste noch halbiert werden.

Weitere Anwendungsmöglichkeiten für das erfindungsgemäße bipolare Hochvolt-Leistungsbauelement sind beispielsweise Dioden. Bei diesen können die floatenden Gebiete auch direkt mit dem p-leitenden Bereich der Anode verbunden sind, so dass kein zusätzlicher p-MOS-Transistor benötigt wird.

Nachfolgend wird die Erfindung anhand der Zeichnungen näher erläutert. Es zeigen:
- Fig. 1: einen Schnitt durch einen IGBT nach einem ersten Ausführungsbeispiel der Erfindung,
- Fig. 2: einen Schnitt durch eine Diode nach einem zweiten Ausführungsbeispiel der Erfindung und
- Fig. 3: einen Schnitt durch einen IGBT nach einem dritten Ausführungsbeispiel der Erfindung.

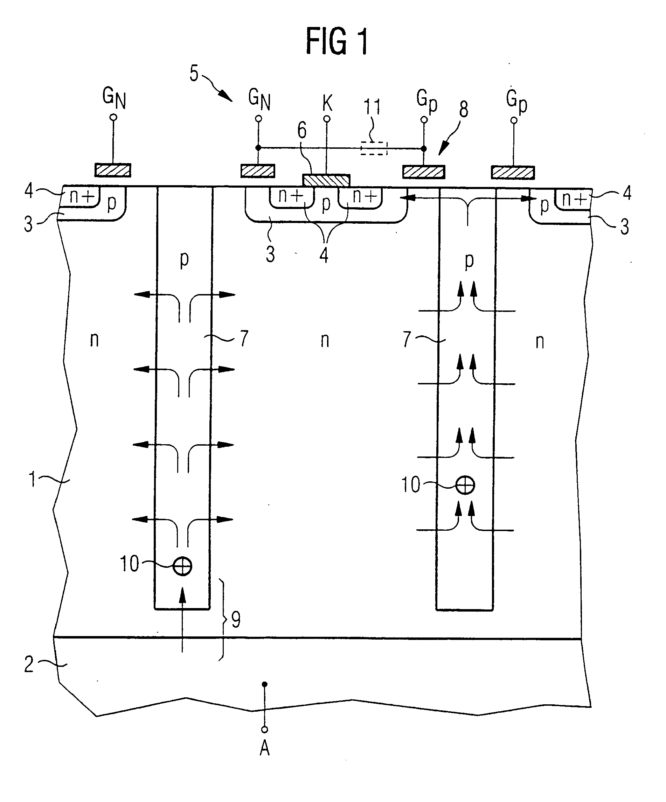

Fig. 1 zeigt einen Schnitt durch einen IGBT mit einem n-leitenden Halbleitergebiet 1 auf einem p⁺-leitenden Halbleitersubstrat 2, das einen mit einer Anode A verbundenen Emitter bildet. In der dem Halbleitersubstrat gegenüberliegenden Oberfläche des Halbleitergebietes 1 sind p-leitende Halbleiterbereiche 3 eingebracht, in denen sich n⁺-leitende Sourcezonen 4 befinden.

Das Halbleitersubstrat 2, der Halbleiterkörper 1, der Halbleiterbereich 3 und die Sourcezonen 4 bestehen vorzugsweise aus Silizium. Gegebenenfalls können aber auch andere Halbleitermaterialien verwendet werden.

Die Sourcezonen 4 und der Halbleiterbereich 3 bilden zusammen mit dem Halbleiterkörper 1 einen n-MOS-Transistor 5 mit einer Gateelektrode G_{N}, die oberhalb des Halbleiterbereiches 3 (body) angeordnet ist. Außerdem ist noch eine Kathodenelektrode 6 mit einem Kathodenanschluss K gezeigt, welche den Halbleiterbereich 3 und die Sourcezonen 4 kontaktiert.

In dem Halbleitergebiet 1 befinden sich p-leitende Zonen 7, die vorzugsweise floatend sind, also nicht in Verbindung mit dem Halbleiterbereich 3 stehen.

Die in der Fig. 1 rechte floatende Halbleiterzone 7 bildet zusammen mit einer Gateelektrode G_{P}, dem Halbleiterbereich 3 und dem zwischen dem Halbleiterbereich 3 und der floatenden Zone 7 gelegenen Teil des Halbleitergebietes 1 einen p-MOS-Transistor 8. Außerdem bildet die in der Fig. 1 linke floatende Halbleiterzone 7 mit dem Halbleitergebiet 1 und dem Halbleitersubstrat 2 einen pnp-Transistor 9.

Die floatenden Zonen 7 haben die Aufgabe, die Minoritätsladungsträger, die im vorliegenden Bereich Löcher, durch ohmsche Leitung in die zwischen den p-leitenden Zonen 7 befindlichen Bereiche des n-leitenden Halbleiterkörpers 1 einzubringen bzw. von dort abzuleiten. Diese floatenden Zonen 7 sind dabei durch den pnp-Transistor 9 an den p-leitenden Emitter bzw. die Anode A des IGBT's und durch den p-MOS-Transistor 8 an den Halbleiterbereich 3 (body) angeschlossen. Anstelle des MOS-Transistors 8 und des pnp-Transistors 9 kann auch jeweils ein Bipolartransistor (für den MOS-Transistor 8) bzw. ein MOS-Transistor (für den Bipolartransistor 9) verwendet werden.

Das Kanalgebiet des MOS-Transistors 5 bildet gleichzeitig das Drain- bzw. Kollektorgebiet des MOS- bzw. Bipolartransistors 8.

Beim Einschalten des IGBT (vgl. linke Hälfte von Fig. 1) werden dann die Löcher (vgl. Bezugszeichen 10) über den pnp-Transistor 9 und die Zone 7 in die Driftstrecke des Halbleitergebietes 1 transportiert. Beim Abschalten (vgl. rechte Hälfte von Fig. 1) wird der p-MOS-Transistor 8 eingeschaltet, so dass die Minoritätsladungsträger aus dem Halbleitergebiet 1 über die Zone 7 als Minoritätsladungsträger und den p-MOS-Transistor 8 abfließen können. Das Einfließen und Abfließen der Löcher 10 ist in der Fig. 1 jeweils durch Pfeile veranschaulicht.

Obwohl in Fig. 1 der Einschalt- und der Ausschaltvorgang beide dargestellt sind, findet in den beiden Zonen 7 selbstverständlich gleichzeitig immer nur ein Einschaltvorgang oder ein Ausschaltvorgang statt. Das heißt, beim Einschalten liegen in beiden Zonen 7 die links gezeigten Verhältnisse vor, während beim Ausschalten die rechts dargestellten Bedingungen anzutreffen sind.

Die Gateelektroden G_{N} und G_{P} des n-MOS-Transistors 5 und des p-MOS-Transistors 8 können miteinander verbunden sein, wie dies in Fig. 1 gezeigt ist. Gegebenenfalls kann noch ein Verzögerungsglied 11 in der Verbindungsleitung zwischen den Gateleektroden G_{N} und G_{P} vorhanden sein. Damit ist es möglich, zur Reduzierung der Abschaltverluste zuerst den p-MOS-Transistor 8 einzuschalten und sodann mit einer Verzögerung von beispielsweise 1 µs den n-MOS-Transistor 5 auszuschalten. Anstelle eines Verzögerungsgliedes 11 kann gegebenenfalls auch eine zeitlich versetzte bzw. getrennte Ansteuerung der beiden Gateelektroden Gp und G_{N}, die dann nicht miteinander verbunden sind, vorgenommen werden.

Die Transistoren 5, 8 sind in bevorzugter Weise getrennt und extern ansteuerbar.

Die Dotierungskonzentrationen des Halbleitergebietes 1 bzw. der Halbleiterzonen 7 sind so eingestellt, dass ein ausreichend schnelles Abfließen der Löcher 10 bei noch geringer Spannung erfolgt. Die Dotierungskonzentrationen liegen im Bereich zwischen 5 x 10¹⁴ und 5 x 10¹⁶ Ladungsträger cm⁻³.

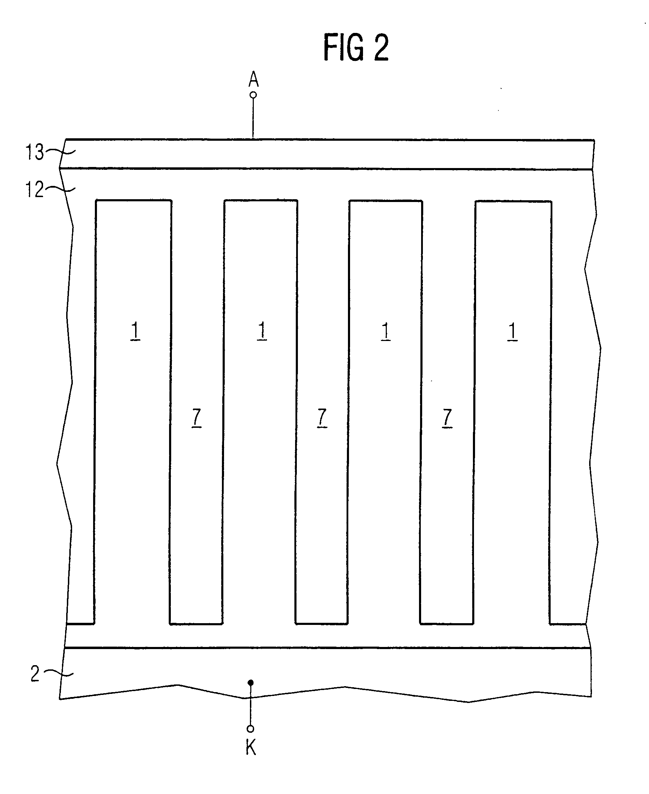

Fig. 2 zeigt ein weiteres Ausführungsbeispiel der Erfindung als Diode, bei der in ein n-leitendes Halbleitergebiet 1 p-leitende Zonen 7 eingebettet sind, die hier direkt mit einem p-leitenden Gebiet 12 unterhalb einer Aluminiumschicht 13 einer Anode A verbunden sind. Eine Kathode K ist an ein n⁺-leitendes Halbleitersubstrat 2 angeschlossen. Bei einer solchen Gestaltung ist kein zusätzlicher p-MOS-Transistor 8 erforderlich.

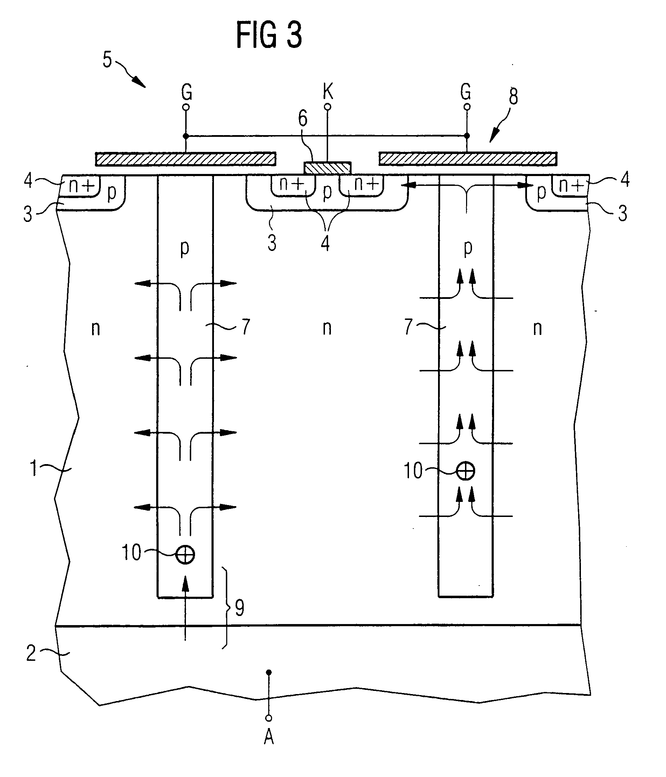

Schließlich zeigt Fig. 3 noch ein weiteres Ausführungsbeispiel der Erfindung, bei dem zwischen benachbarten IGBT-Zellen die Gates zusammenhängen, so dass Gₚ = G_{N} gilt.

Das erfindungsgemäße bipolare Hochvolt-Leistungsbauelement kann vertikal oder lateral aufgebaut sein, d.h. die Driftstrecke des ersten Leitungstyps und die Zonen 7 des zweiten Leitungstyps können im Wesentlichen parallel oder senkrecht zur Oberfläche des Halbleiterkörpers 1 angeordnet sein.

## Patentansprüche

1. Bipolares Hochvolt-Leistungsbauelement mit einem Halbleiterkörper (2, 1), auf dem wenigstens zwei voneinander beabstandete Elektroden (A, K) vorgesehen sind, zwischen denen eine Driftstrecke in einem Halbleitergebiet (1) eines ersten Leistungstyps ausgebildet ist, in dem floatende Zonen (7) des zweiten, zum ersten Leitungstyp entgegengesetzten Leitungstyps vorgesehen sind, die sich zwischen der einen Elektrode (K) und der anderen Elektrode (A) erstrecken,
**dadurch gekennzeichnet,**
**dass** das Halbleitergebiet (1) und die floatenden Zonen (7) jeweils eine Dotierungskonzentration von etwa 5 x 10¹⁴ bis 5 x 10¹⁶ Ladungsträger cm⁻³ aufweisen.

2. Bipolares Hochvolt-Leistungsbauelement nach Anspruch 1,
**dadurch gekennzeichnet,**
**dass** die floatenden Zonen (7) über jeweils einen ersten MOS-Transistor (8) mit einem Kanal des zweiten Leitungstyps und über einen Bipolartransistor (9) mit einer Basis des ersten Leitungstyps an mit den beiden Elektroden (K, A) verbundene aktive Bereiche (3, 2) des Leistungsbauelements angeschlossen sind.

3. Bipolares Hochvolt-Leistungsbauelement nach Anspruch 2,
**gekennzeichnet durch**
einen zweiten MOS-Transistor (5) mit einem Kanal des ersten Leitungstyps zum Ein- und Ausschalten des Leistungsbauelements.

4. Bipolares Hochvolt-Leistungsbauelement nach Anspruch 3,
**dadurch gekennzeichnet,**
**dass** die Gates der beiden MOS-Transistoren (8, 5) zusammengeschaltet sind.

5. Bipolares Hochvolt-Leistungsbauelement nach Anspruch 4,
**dadurch gekennzeichnet,**
**dass** zwischen den Gates der beiden MOS-Transistoren (8, 5) ein Verzögerungsglied (11) vorgesehen ist.

6. Bipolares Hochvolt-Leistungsbauelement nach Anspruch 4,
**dadurch gekennzeichnet,**
**dass** die beiden MOS-Transistor (8, 5) getrennt und extern ansteuerbar sind.

7. Bipolares Hochvolt-Leistungsbauelement nach einem der Ansprüche 1 bis 6,
**dadurch gekennzeichnet,**
**dass** das Leistungsbauelement ein IGBT oder eine Diode ist.

8. Bipolares Hochvolt-Leistungsbauelement nach Anspruch 3,
**dadurch gekennzeichnet,**
**dass** das Kanalgebiet (3) des zweiten MOS-Transistors (5) gleichzeitig das Draingebiet des ersten MOS-Transistors (8) ist.

9. Bipolares Hochvolt-Leistungsbauelement nach einem der Ansprüche 1 bis 8,
**dadurch gekennzeichnet,**
**dass** die Driftstrecke des ersten Leitungstyp und die Zonen (7) des zweiten Leitungstyps im Wesentlichen parallel zur Oberfläche des Halbleiterkörpers (2, 1) angeordnet sind.

10. Bipolares Hochvolt-Leistungsbauelement nach einem der Ansprüche 1 bis 9,
**dadurch gekennzeichnet,**
**dass** die Driftstrecke des ersten Leitungstyps und die Zonen (7) des zweiten Leitungstyps im Wesentlichen senkrecht zur Oberfläche des Halbleiterkörpers (2, 1) angeordnet sind.

## Claims

1. Bipolar high-voltage power component having a semiconductor body (2, 1), on which at least two electrodes (A, K) spaced apart from one another are provided, between which a drift path is formed in a semiconductor region (1) of a first conduction type, in which floating zones (7) of the second conduction type, opposite to the first conduction type, are provided, which extend between one electrode (K) and the other electrode (A),
**characterized**
**in that** the semiconductor region (1) and the floating zones (7) each have a doping concentration of about 5 x 10¹⁴ to 5 x 10¹⁶ charge carriers cm⁻³.

2. Bipolar high-voltage power component according to Claim 1,
**characterized**
**in that** the floating zones (7) are connected, via a respective first MOS transistor (8) with a channel of the second conduction type and via a bipolar transistor (9) with a base of the first conduction type, to active regions (3, 2) of the power component which are connected to the two electrodes (K, A).

3. Bipolar high-voltage power component according to Claim 2,
**characterized by**
a second MOS transistor (5) with a channel of the first conduction type for switching the power component on and off.

4. Bipolar high-voltage power component according to Claim 3,
**characterized**
**in that** the gates of the two MOS transistors (8, 5) are connected together.

5. Bipolar high-voltage power component according to Claim 4,
**characterized**
**in that** a delay element (11) is provided between the gates of the two MOS transistors (8, 5).

6. Bipolar high-voltage power component according to Claim 4,
**characterized**
**in that** the two MOS transistors (5, 8) can be driven separately and externally.

7. Bipolar high-voltage power component according to one of Claims 1 to 6,
**characterized**
**in that** the power component is an IGBT or a diode.

8. Bipolar high-voltage power component according to Claim 3,
**characterized**
**in that** the channel region (3) of the second MOS transistor (5) is simultaneously the drain region of the first MOS transistor (8).

9. Bipolar high-voltage power component according to one of Claims 1 to 8,
**characterized**
**in that** the drift path of the first conduction type and the zones (7) of the second conduction type are arranged essentially parallel to the surface of the semiconductor body (2, 1).

10. Bipolar high-voltage power component according to one of Claims 1 to 9,
**characterized**
**in that** the drift path of the first conduction type and the zones (7) of the second conduction type are arranged essentially perpendicular to the surface of the semiconductor body (2, 1).

## Revendications

1. Composant de puissance bipolaire de haute tension, comprenant un corps (2, 1) semi-conducteur sur lequel sont prévues au moins deux électrodes (A, K) qui sont à distance l'une de l'autre et entre lesquelles est formée une section de drift dans un domaine (1) semi-conducteur d'un premier type de conductivité, dans lequel il est prévu des zones (7) flottantes du deuxième type de conductivité opposé au premier type de conductivité, qui s'étendent entre l'une des électrodes (K) et l'autre électrode (A),
**caractérisé**
**en ce que** le domaine (1) semi-conducteur et les zones (7) flottantes ont respectivement une concentration de dopage allant de 5 x 10¹⁴ à 5 x10¹⁶ porteurs de charge cm⁻³.

2. Composant de puissance bipolaire de haute tension suivant la revendication 1,
**caractérisé**
**en ce que** les zones (7) flottantes sont, par respectivement un premier transistor (8) MOS ayant un canal du deuxième type de conductivité et par un transistor (9) bipolaire ayant une base du premier type de conductivité, raccordés à des domaines (3, 2) actifs du composant de puissance reliés aux deux électrodes (K, A).

3. Composant de puissance bipolaire de haute tension suivant la revendication 2,
**caractérisé**
**par** un deuxième transistor (5) MOS ayant un canal du premier type de conductivité pour mettre en circuit et hors circuit le composant de puissance.

4. Composant de puissance bipolaire de haute tension suivant la revendication 3,
**caractérisé**
**en ce que** les grilles des deux transistors (8, 5) MOS sont câblées ensemble.

5. Composant de puissance bipolaire de haute tension suivant la revendication 4,
**caractérisé**
**en ce qu'**il est prévu un élément (11) temporisateur entre les grilles des deux transistors (8, 5) MOS.

6. Composant de puissance bipolaire de haute tension suivant la revendication 4,
**caractérisé**
**en ce que** les deux transistors (8, 5) MOS peuvent être commandés séparément et de l'extérieur.

7. Composant de puissance bipolaire de haute tension suivant l'une des revendications 1 à 6,
**caractérisé**
**en ce que** le composant de puissance est un IGBT ou une diode.

8. Composant de puissance bipolaire de haute tension suivant la revendication 3,
**caractérisé**
**en ce que** le domaine (3) de canal du deuxième transistor (5) MOS est en même temps le domaine de drain du premier transistor (8) MOS.

9. Composant de puissance bipolaire de haute tension suivant l'une des revendications 1 à 8,
**caractérisé**
**en ce que** la section de drift du premier type de conductivité et les zones (7) du deuxième type de conductivité sont disposées sensiblement parallèlement à la surface du corps (2, 1) semi-conducteur.

10. Composant de puissance bipolaire de haute tension suivant l'une des revendications 1 à 9,
**caractérisé**
**en ce que** la section de drift du premier type de conductivité et les zones (7) du deuxième type de conductivité sont disposées sensiblement perpendiculairement à la surface du corps (2, 1) semi-conducteur.
